# EUROPEAN PATENT APPLICATION

(11) **EP 3 010 319 A1**
(43) Date of publication of application: **20.04.2016**
(21) Application number: 14188923.8
(22) Date of filing: 15.10.2014
(51) Int. Cl.: H05K 7/14

(54) **Industrial server system**

(71) Applicant: Lanner Electronic Inc., New Taipei City 221 (TW)
(72) Inventor: Lin, Tse Min, 221 New Taipei City (TW)
(74) Representative: Becker Kurig Straus

(57) **Abstract**

The present invention relates to an industrial server system, comprising a housing (11), a backplane (12), at least one rear board (13), a first front board (14), a second front board (15), and a power supply (16), wherein the backplane and the power supply are disposed in the housing, and the rear board, the first front board, and the second front board are coupled and configured to the backplane. Four connected blocks are disposed on the backplane, which makes that at least one rear board, the first front board, and the second front board are able to communicate to each other by a plurality of data connecting units disposed on the backplane. The rear board, the first front board, and the second front board of the present invention can achieve a great transmission efficiency by a specific configuration of connected block on the backplane.

## Description

### BACKGROUND OF THE INVENTION

### 1. Field of the Invention

The present invention relates to an industrial server system, and more particularly, to an industrial server system compatible with advanced telecom computing architecture.

### 2. Description of the Prior Art

Modular systems are typically used in communication networks where reliability and cost effectiveness are important factors. Such modular systems include one or more backplanes that receive and couple to other interoperable pieces such as circuit boards or "boards". These boards may include, but are not limited to blades, carrier boards, processing boards, interconnects, etc. Other interoperable pieces that a backplane may receive and couple to include components such as fans, power equipment modules (PEM), field replaceable units (FRUs), alarm boards, etc.

Backplanes within a modular platform system may receive and couple boards via one or more data transport and power connectors. Typically, the one or more data transport connectors include communication links to interconnect boards received and coupled to the backplane. These communication links may also couple interconnected boards to components resident on a given board (e.g., mezzanine cards, processing elements, chipsets, media devices, etc.). Data and/or instructions are forwarded on these communication links using various different communication protocols. Typically a data transport interface is used to serve as a bridge between the communication links that use different communication protocols.

The inventor of the present application has made great efforts to make inventive research thereon and eventually provided an industrial server system.

### SUMMARY OF THE INVENTION

The primary objective of the present invention is to dispose four connected blocks on a backplane, such that at least one rear board and at least one front board are able to communicate to each other by a plurality of data connecting units disposed on the backplane. Thus, The rear board, the first front board, and the second front board of the present invention can achieve a great transmission efficiency by a specific configuration of connector on the backplane.

Accordingly, to achieve the primary objective of the present invention, the inventor of the present invention provides an industrial server system, comprising:
a housing;
a backplane disposed in the housing comprises:
   a first connected block consists of:
      a first transmitting area disposed on the obverse side of the backplane;
      a second transmitting area disposed on the obverse side of the backplane; and
      a plurality of first data connected areas disposed on the reverse side of the backplane in a column;
   a second connected block located beside the first connected block consists of:
      a third transmitting area disposed on the obverse side of the backplane and located beside the first data connected areas contrary to the second transmitting area;
      a first circulation opening area disposed on the backplane and located nearby the third transmitting area, for circulating the air in front of and behind the backplane;
      a second circulation opening area disposed on the backplane and located nearby the third transmitting area, for circulating the air in front of and behind the backplane;
      a fourth transmitting area disposed on the obverse side of the backplane and located nearby the first circulation opening area and the second circulation opening area;
      a plurality of second data connected areas disposed on the reverse side of the backplane in a column; and
      a plurality of first power supply areas disposed on the reverse side of the backplane and located nearby the second data connected areas;
   a third connected block , located beside the second connected block contrary to the first connected block, consists of:
      a fifth transmitting area disposed on the obverse side of the backplane;
      a sixth transmitting area disposed on the obverse side of the backplane and located nearby the fifth transmitting area;
      a second power supply area disposed on the obverse side of the backplane and located beside the fifth transmitting area; and
      a third power supply area disposed on the obverse side of the backplane and located beside the sixth transmitting area; and
   a fourth connected block, located beside the third connected block contrary to the second connected block;
at least one rear board connected to the reverse side of the backplane has a first data connector, a second data connector, and a first power supply connector, wherein the first data connector, the second data connector, and the first power supply connector are correspondingly connected to the first data connected areas, the second data connected areas, and the first power supply areas;
a first front board connected to the obverse side of the backplane has a first transmitting connector, a fourth transmitting connector, a fifth transmitting connector, and a second power supply connector, wherein the first transmitting connector, the fourth transmitting connector, the fifth transmitting connector, and the second power supply connector are correspondingly connected to the first transmitting area, the fourth transmitting area, fifth transmitting area, and the second power supply area;
a second front board connected to the obverse side of the backplane has a second transmitting connector, a third transmitting connector, a sixth transmitting connector, and a third power supply connector, wherein the second transmitting connector, the third transmitting connector, the sixth transmitting connector, and the third power supply connector are correspondingly connected to the second transmitting area, the third transmitting area, sixth transmitting area, and the third power supply area; and
a power supply, disposed in the housing and connected to the fourth connected block.

### BRIEF DESCRIPTION OF THE DRAWINGS

The invention as well as a preferred mode of uses and advantages thereof will be best understood by referring to the following detailed description of an illustrative embodiment in conjunction with the accompanying drawings, wherein:
FIG. 1 is a stereo view of an industrial server system according to the present invention;
FIG. 2 is a stereo view of part of the industrial server system;
FIG. 3 is a schematic view of the obverse side of the backplane;
FIG. 4 is a stereo view of the first front board;
FIG. 5 is a stereo view of the second front board;
FIG. 6 is a schematic view of the reverse side of the backplane; and
FIG. 7 is a stereo view of the rear board.

### DETAILED DESCRIPTION OF THE PREFERRED EMBODIMENTS

To more clearly describe an industrial server system according to the present invention, embodiments of the present invention will be described in detail with reference to the attached drawings hereinafter.

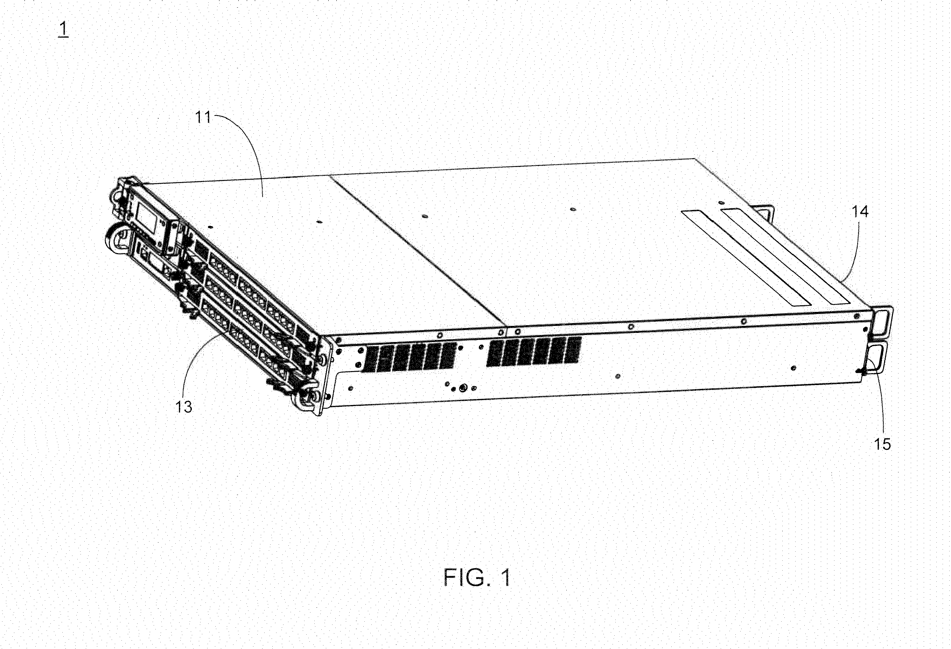

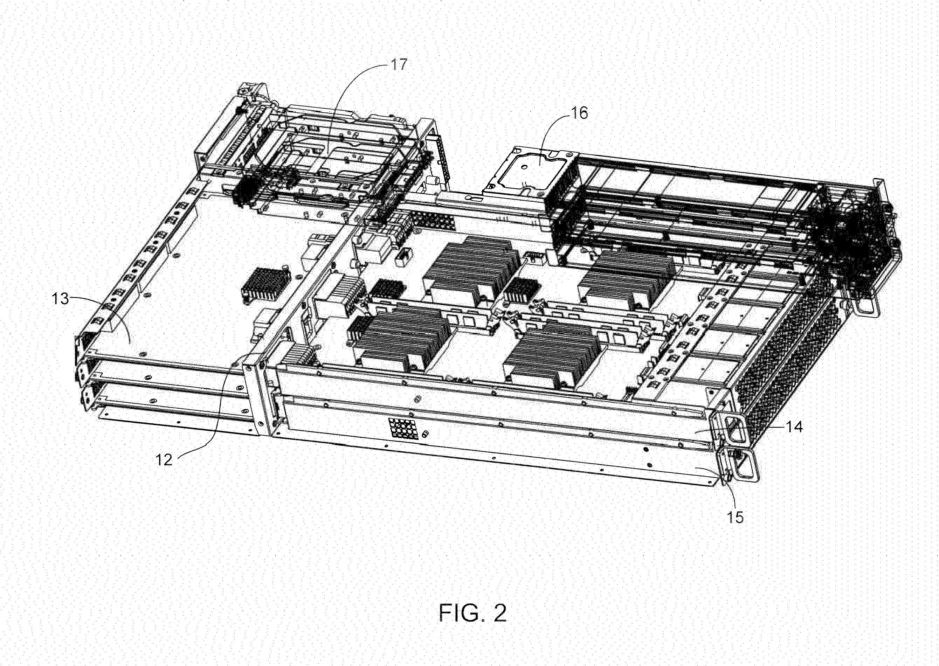

With reference to FIG. 1, which illustrate a stereo view of an industrial server system according to the present invention. Moreover, please simultaneously refer to FIG. 2, there is shown a stereo view of part of the industrial server system. As shown in FIG. 1 and FIG. 2, the industrial server system 1 comprises a housing 11, a backplane 12, at least one rear board 13, a first front board 14, a second front board 15, and a power supply 16, wherein the backplane 12 and the power supply 16 are disposed on the housing 11, and the rear board 13, the first front board 14, and the second front board 15 are coupled and configured to the backplane 12.

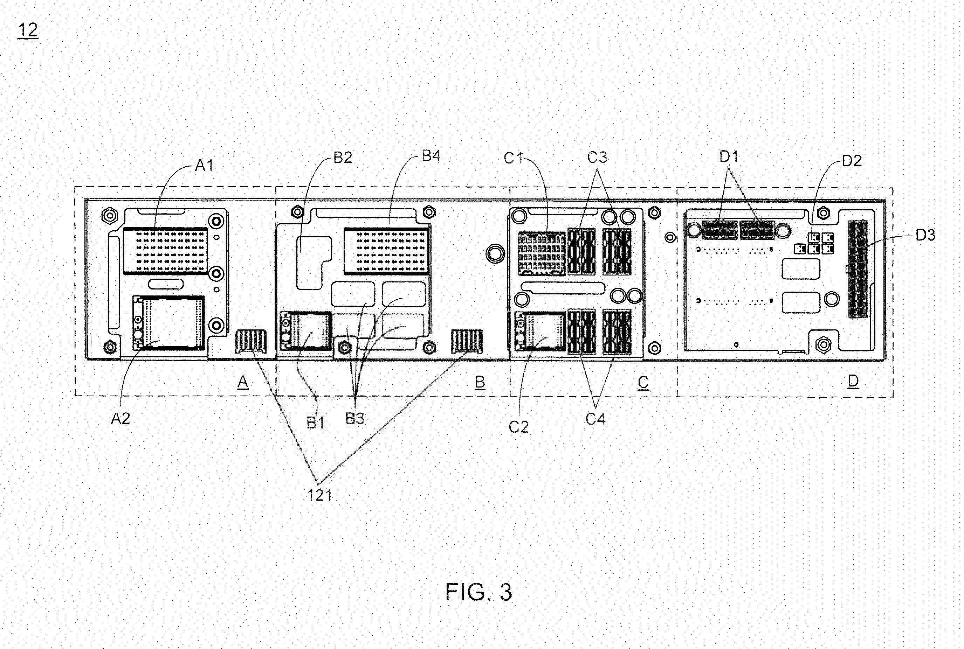

Please refer to FIG. 3, which illustrates a schematic view of the obverse side of the backplane. As FIG. 3 shows, the backplane 12 comprises a first connected block A, a second connected block B, a third connected block C, and a fourth connected block D, wherein the second connected block B locates beside the first connected block A, the third connected block C locates beside the second connected block B contrary to the first connected block A, and the fourth connected block D locates beside the third connected block C contrary to the second connected block B.

Inheriting to above descriptions, the configuration of the obverse side of the backplane 12 will be fully described by following statements. The first connected block A consists of a first transmitting area A1 and a second transmitting area A2 which disposed on the upper and lower half of the backplane 12, respectively. The second connected block B located on the right side of the first connected block A consists of a third transmitting area B1 disposed on the lower half of the second connected block B, a first circulation opening area B2 located over the third transmitting area B1, a second circulation opening area B3 located on the right side of the third transmitting area B1, and a fourth transmitting area B4 located on the right side of the first circulation opening area B2 and over the second circulation opening area B3.

The third connected block C located on the right side of the second connected block B consists of a fifth transmitting area C1 and a sixth transmitting area C2 which disposed on the upper and lower half of the third connected block C, respectively. Moreover, the third connected block C further comprises a second power supply area C3 and a third power supply area C4 which disposed on the right side of the fifth transmitting area C1 and the sixth transmitting area C2, respectively. The fourth connected block D located on the right side of the third connected block C consists of a first power supply area D1 disposed on the upper half of the fourth connected block D for receiving electricity provided by the power supply 16, a control module area D2 disposed on the right side of the first power supply area D1 for monitoring the industrial server system 1, and a second power supply area D3 disposed on the right side of the control module area D2 for receiving electricity provided by the power supply 16. The control module area D2 is a control transmitting interface to the power supply 16 for status displaying, hardware/software resetting, and power switching.

Thus, through above descriptions, the configuration of the obverse side of the backplane 12 has been introduced completely and clearly. Herein, it needs to further explain that the backplane 12 further comprises at least one third circulation opening area formed on unused area of the backplane 12 for better cooling effect. Besides, the backplane 12 is fixed in the housing 11 by at least one fixer 121 disposed on the obverse side of the backplane 12.

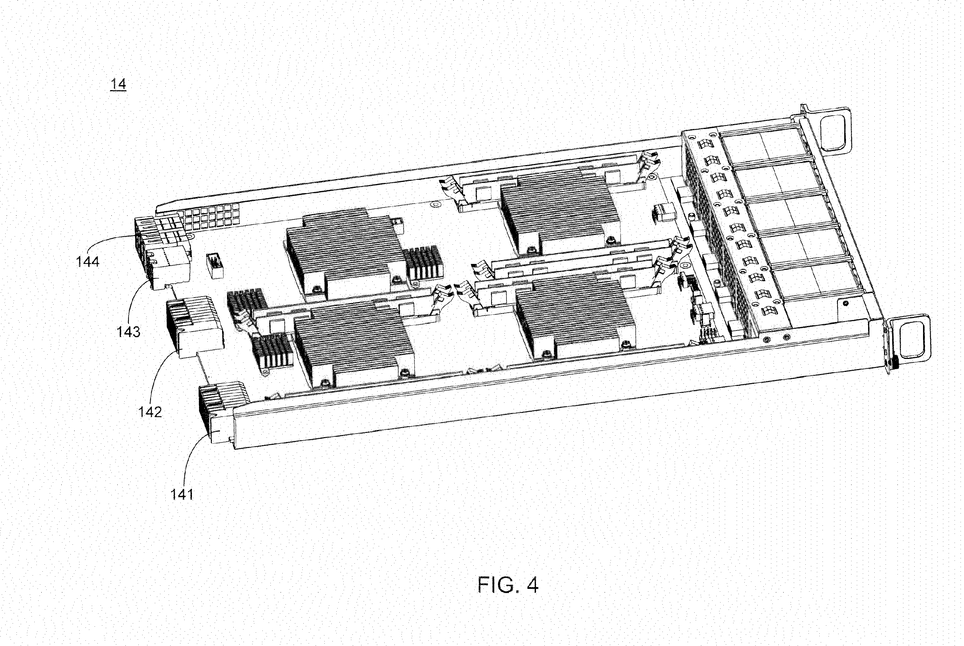

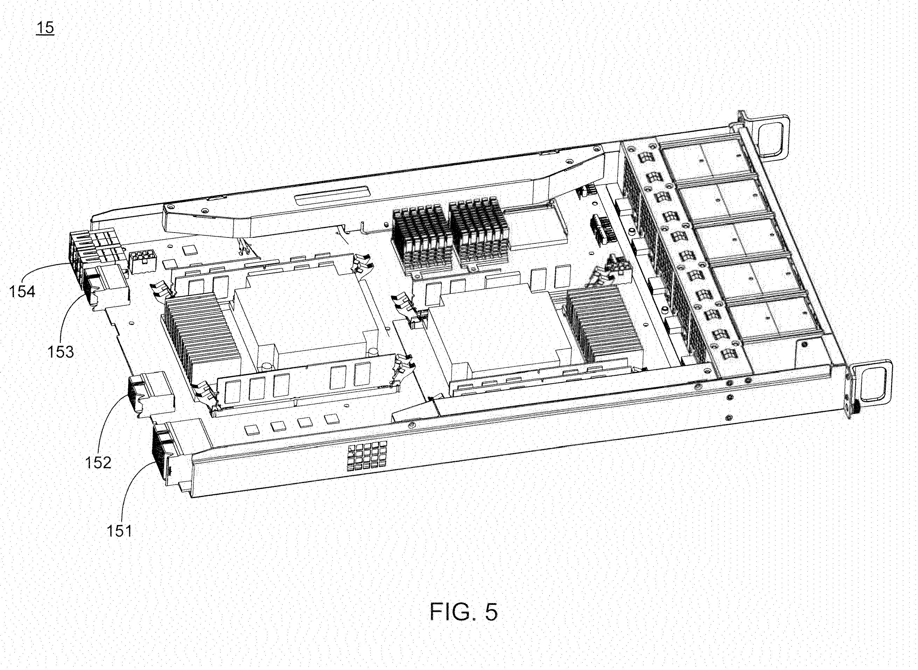

Referring to FIG. 3 again, and please simultaneously refer to FIG. 4 and FIG. 5, which illustrate a stereo view of the first front board and the second front board, respectively. As FIG. 4 shows, the first front board 14 connected to the obverse side of the backplane 12 has a first transmitting connector 141, a fourth transmitting connector 142, a fifth transmitting connector 143, and a second power supply connector 144, wherein the first transmitting connector 141, the fourth transmitting connector 142, the fifth transmitting connector 143, and the second power supply connector 144 are correspondingly connected to the first transmitting area A1, the fourth transmitting area B4, fifth transmitting area C1, and the second power supply area C3. As FIG. 5 shows, the second front board 15 connected to the obverse side of the backplane 12 has a second transmitting connector 151, a third transmitting connector 152, a sixth transmitting connector 153, and a third power supply connector 154, wherein the second transmitting connector 151, the third transmitting connector 152, the sixth transmitting connector 153, and the third power supply connector 154 are correspondingly connected to the second transmitting area A2, the third transmitting area B1, sixth transmitting area C2, and the third power supply area C4. The first front board 14 and the second front board 15 both comprise an intelligent platform management controller (IPMC) for monitoring and recording processes of the first front board 14 and the second front board 15, as well as reporting and dealing with abnormal events; moreover, the IPMC is also used for managing a power switch and at least one data channel switch of the first front board 14 and the second front board 15, wherein the first front board 14 further comprises a reduced instruction set computing (RISC) and the second front board 15 further comprises a complex instruction set computer (CISC).

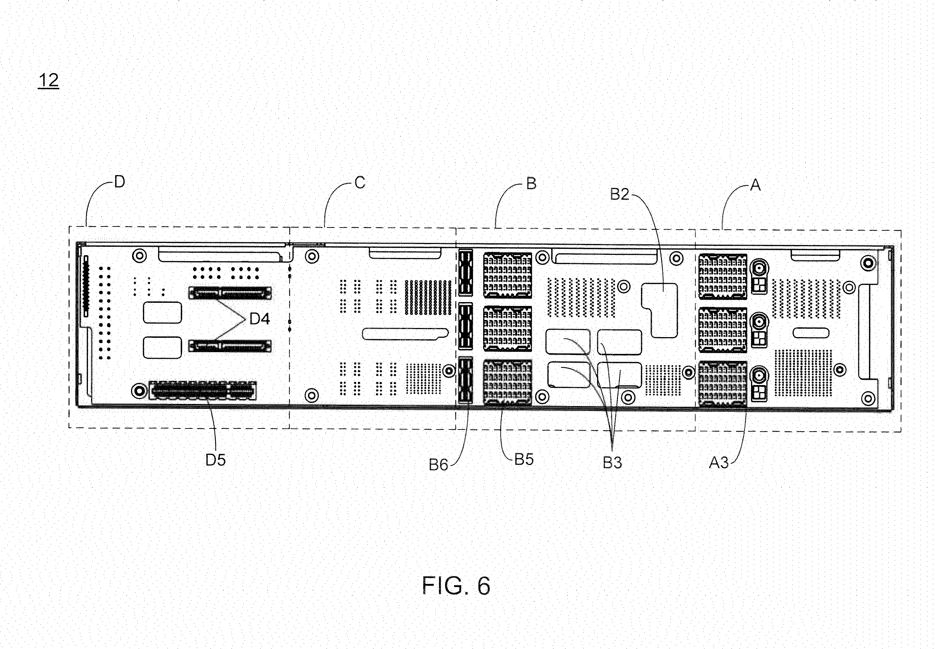

Inheriting to above descriptions, the configuration of the obverse side of the backplane 12 will be fully described by following statements. Please refer to FIG. 6, which illustrates a schematic view of the reverse side of the backplane. As FIG. 6 shows, the first connected block A includes three first data connected areas A3 disposed on the reverse side of the backplane 12 in a column, wherein the first data connected areas A3 is located beside the second connected block B. The second connected block B includes three second data connected areas B5 disposed on the reverse side of the backplane 12 in a column, and three first power supply areas B6 disposed in a column on the left side of the second data connected areas B5, wherein the first power supply areas B6 is located beside the third connected block C. The second connected block D includes a data storage device slot area D4 located beside the third connected block C and a input/output area D5 located beneath the data storage device slot area D4 for coupling at least one electric module, wherein the data storage device slot area D4 has two hard disc drive slot for coupling at least one hard disc drive. Besides, the aforesaid electric module is selected from the group consisting of: universal serial bus, local area network, wireless local area network, integrated drive electronics, audio device, advanced technology attachment, audio device and other input/output device. Referring FIG. 3 again, the sixth transmitting area C2 is a transmitting interface for the second front board 15 to the control module area D2, the data storage device slot area D4, and the input/output area D5.

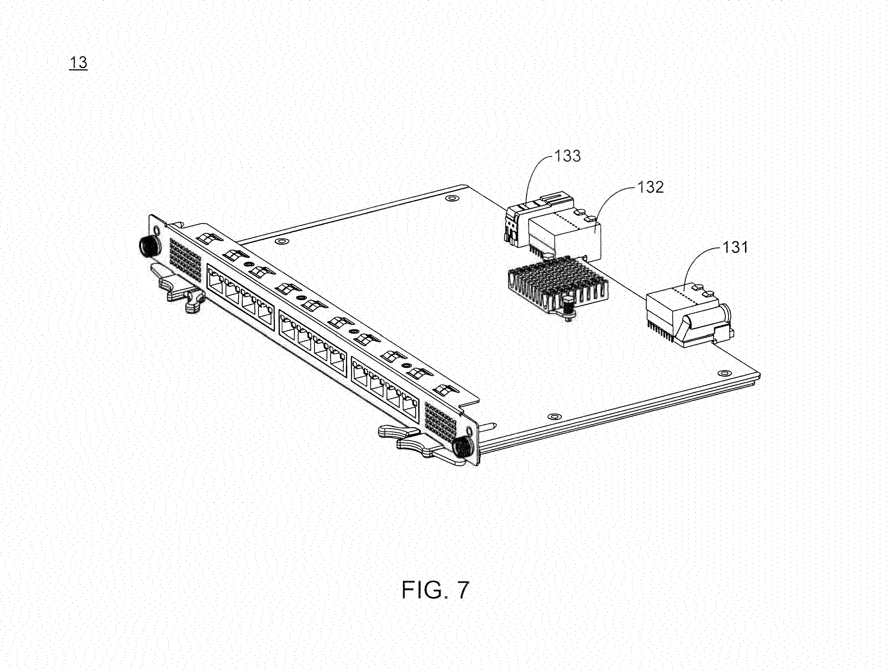

Please refer to FIG. 6 and simultaneously refer to FIG. 7, there is shown a stereo view of the rear board. As shown in FIG. 7, at least one rear board 13 connected to the reverse side of the backplane 12 has a first data connector 131, a second data connector 132, and a first power supply connector 133, wherein the first data connector 131, the second data connector 132, and the first power supply connector 133 are correspondingly connected to the first data connected areas A3, the second data connected areas B5, and the first power supply areas B6. The rear board 13 is an advanced mezzanine card comprising a communication channel, a module management controller, a module controlling logic, a module memory, an input/output interface, a module interface, a hot-swap electronics, and an extended application unit, wherein said module memory is selected from the group consisting of: volatile memory, non-volatile memory, flash memory, random access memory, and read-only memory; and said module controlling logic is selected from the group consisting of: microprocessor, network processor, micro controller unit, field programmable gate array, and application specific integrated circuit.

Inheriting to above descriptions, in a prefer embodiment of present invention, the industrial server system 1 is disposing three rear boards 13, a first front board 14, and a second front board 15 on a backplane 12. Regarding the second front board 15 as a primary input and regarding the first front board 14 as a secondary input, wherein the second front board 15 transmits data signals to the backplane 12 through the second transmitting area A2 and the third transmitting area B1. The second transmitting area A2 includes two PCIe x8 and two PCIe x4. The third transmitting area B1 includes two PCIe x8. On the other hand, the first front board 14 receives the data signals transmitted from the second front board 15 through a PCIe x8 of the first transmitting area A1. Moreover, the first front board 14 further transmits the data signals to the backplane 12 through two PCIe x4 and three XAUI of the first transmitting area A1, and fourth transmitting area B4 and the fifth transmitting area C1, wherein the fourth transmitting area B4 includes six XAUI, the fifth transmitting area C1 includes three XAUI.

Each rear board 13 receives the data signals transmitted from the first front board 14 and the second front board 15 through a XAUI and a PCIe x8 of each first data connected area A3. Moreover, each rear board 13 also receives the data signals transmitted from the first front board 14 through three XAUI of each second data connected area B5.

Thus, through the foregoing descriptions, the industrial server system has been completely introduced and disclosed; in summary, the present invention has the following advantages:
1. In the present invention, a backplane 12 is dispose four connected blocks(A, B, C, D), such that at least one rear board and at least one front board are able to communicate to each other by a plurality of data connecting units disposed on the backplane. Particularly, the third connected block C in the present invention is located beside the fourth connected block D, which makes the second power supply area C3 and the third power supply area C4 close to the first power supply area D1 and the second power supply area D3. Thus, the present invention can achieve a great transmission efficiency by aforesaid specific configuration of connected block on the backplane.
2. Inheriting to above point 1, the sixth transmitting area C2, a primary I/O interface, is disposed on the third connected block C for disposing close to the input/output area D5 and increasing transmission efficiency.

3. Moreover, the backplane 12 of the present invention comprises many circulation opening areas for better cooling effect. For example, the first circulation opening area B2 and the second circulation opening area B3 are disposed beside the third transmitting area B1 and the fourth transmitting area B4, respectively, for corresponding to principle circuits and electronic components of the first front board 14 and the second front board 15.

The above description is made on embodiments of the present invention. However, the embodiments are not intended to limit scope of the present invention, and all equivalent implementations or alterations within the spirit of the present invention still fall within the scope of the present invention.

## Claims

1. An industrial server system, comprising:
a housing ;
a backplane disposed in the housing comprises:
a first connected block consists of:
a first transmitting area disposed on the obverse side of the backplane;
a second transmitting area disposed on the obverse side of the backplane; and
a plurality of first data connected areas disposed on the reverse side of the backplane in a column;
a second connected block located beside the first connected block consists of:
a third transmitting area disposed on the obverse side of the backplane and located beside the first data connected areas contrary to the second transmitting area;
a first circulation opening area disposed on the backplane and located nearby the third transmitting area, for circulating the air in front of and behind the backplane;
a second circulation opening area disposed on the backplane and located nearby the third transmitting area, for circulating the air in front of and behind the backplane;
a fourth transmitting area disposed on the obverse side of the backplane and located nearby the first circulation opening area and the second circulation opening area;
a plurality of second data connected areas disposed on the reverse side of the backplane in a column; and
a plurality of first power supply areas disposed on the reverse side of the backplane and located nearby the second data connected areas;
a third connected block , located beside the second connected block contrary to the first connected block , consists of:
a fifth transmitting area disposed on the obverse side of the backplane;
a sixth transmitting area disposed on the obverse side of the backplane and located nearby the fifth transmitting area;
a second power supply area disposed on the obverse side of the backplane and located beside the fifth transmitting area; and
a third power supply area disposed on the obverse side of the backplane and located beside the sixth transmitting area; and
a fourth connected block, located beside the third connected block contrary to the second connected block;
at least one rear board connected to the reverse side of the backplane has a first data connector, a second data connector, and a first power supply connector, wherein the first data connector, the second data connector, and the first power supply connector are correspondingly connected to the first data connected areas, the second data connected areas, and the first power supply areas;
a first front board connected to the obverse side of the backplane has a first transmitting connector, a fourth transmitting connector, a fifth transmitting connector, and a second power supply connector, wherein the first transmitting connector, the fourth transmitting connector, the fifth transmitting connector, and the second power supply connector are correspondingly connected to the first transmitting area, the fourth transmitting area, fifth transmitting area, and the second power supply area;
a second front board connected to the obverse side of the backplane has a second transmitting connector, a third transmitting connector, a sixth transmitting connector, and a third power supply connector, wherein the second transmitting connector, the third transmitting connector, the sixth transmitting connector, and the third power supply connector are correspondingly connected to the second transmitting area, the third transmitting area, sixth transmitting area, and the third power supply area; and
a power supply, disposed in the housing and connected to the fourth connected block.

2. The industrial server system as recited in claim 1, wherein the fourth connected block comprises:
a first power supply area, disposed on the obverse side of the backplane for receiving electricity provided by the power supply;
a control module area, disposed on the obverse side of the backplane and beside the first power supply area for monitoring the industrial server system;
a second power supply area, disposed on the obverse side of the backplane and beside the control module area for receiving electricity provided by the power supply;
a data storage device slot area, disposed on the reverse side of the backplane for coupling at least one data storage device; and
an input/output area, disposed on the reverse side of the backplane and located beneath the data storage device slot area for coupling at least one electric module.

3. The industrial server system as recited in claim 2, wherein the electric module is selected from the group consisting of: universal serial bus, local area network, wireless local area network, integrated drive electronics, audio device, advanced technology attachment, audio device and other input/output device.

4. The industrial server system as recited in claim 2, wherein the control module area is a control transmitting interface to the power supply for status displaying, hardware/software resetting, and power switching.

5. The industrial server system as recited in claim 1, wherein the rear board is an advanced mezzanine card comprising a communication channel, a module management controller, a module controlling logic, a module memory, an input/output interface, a module interface, a hot-swap electronics, and an extended application unit.

6. The industrial server system as recited in claim 5, wherein the module memory is selected from the group consisting of: volatile memory, non-volatile memory, flash memory, random access memory, and read-only memory.

7. The industrial server system as recited in claim 5, wherein the module controlling logic is selected from the group consisting of: microprocessor, network processor, micro controller unit, field programmable gate array, and application specific integrated circuit.

8. The industrial server system as recited in claim 1, wherein the first transmitting area includes a PCIe x8 (Peripheral Component Interconnect Express), two PCIe x4, and three XAUI.

9. The industrial server system as recited in claim 1, wherein the second transmitting area includes two PCIe x8 and two PCIe x4.

10. The industrial server system as recited in claim 1, wherein the first connected block comprises three first data connected areas, and each first data connected area includes a XAUI and a PCIe x8.

11. The industrial server system as recited in claim 1, wherein the third transmitting area includes two PCIe x8.

12. The industrial server system as recited in claim 1, wherein the fourth transmitting area includes six XAUI.

13. The industrial server system as recited in claim 1, wherein the second connected block comprises three second data connected areas, and each second data connected area includes three XAUI.

14. The industrial server system as recited in claim 1, wherein the fifth transmitting area includes three XAUI.

15. The industrial server system as recited in claim 2, wherein the sixth transmitting area is a transmitting interface for the front board 14 to the control module area, the data storage device slot area, and the input/output area.

16. The industrial server system as recited in claim 1 comprises at least one third circulation opening area formed on unused area of the backplane.

17. The industrial server system as recited in claim 1, wherein the backplane is fixed in the housing by at least one fixer disposed on the obverse side of the backplane.

18. The industrial server system as recited in claim 1, wherein the first front board and the second front board both comprise an intelligent platform management controller (IPMC) for monitoring and recording process of the first front board and the second front board, as well as reporting and dealing with abnormal events; moreover, the IPMC is also used for managing a power switch and at least one data channel switch of the first front board and the second front board.

19. The industrial server system as recited in claim 18, wherein the first front board further comprises a reduced instruction set computing (RISC).

20. The industrial server system as recited in claim 18, wherein the second front board further comprises a complex instruction set computer (CISC).
